# EUROPEAN PATENT APPLICATION

(11) **EP 2 439 316 A1**
(43) Date of publication of application: **11.04.2012**
(21) Application number: 10783347.7
(22) Date of filing: 31.05.2010
(51) Int. Cl.: C30B 29/38, C23C 16/34, C30B 25/20, H01L 21/205

(54) **NITRIDE SEMICONDUCTOR CRYSTAL AND METHOD FOR MANUFACTURING SAME**

(30) Priority: 01.06.2009 JP 2009132264; 19.08.2009 JP 2009190070
(71) Applicant: Mitsubishi Chemical Corporation, Tokyo 108-0014 (JP)
(72) Inventor: KUBO, Shuichi, Ibaraki 300-1295 (JP); SHIMOYAMA, Kenji, Ibaraki 300-1295 (JP); KIYOMI, Kazumasa, Ibaraki 300-1295 (JP); FUJITO, Kenji, Ibaraki 300-1295 (JP); MIKAWA, Yutaka, Ibaraki 300-1295 (JP)
(74) Representative: Siegert, Georg
(86) International application number: PCT/JP2010/059199
(87) International publication number: WO 2010/140564

(57) **Abstract**

A production process for a nitride semiconductor crystal, comprising growing a semiconductor layer on a seed substrate to obtain a nitride semiconductor crystal, wherein the seed substrate comprises a plurality of seed substrates made of the same material, at least one of the plurality of seed substrates differs in the off-angle from the other seed substrates, and a single semiconductor layer is grown by disposing the plurality of seed substrates in a semiconductor crystal production apparatus, such that when the single semiconductor layer is grown on the plurality of seed substrates, the off-angle distribution in the single semiconductor layer becomes smaller than the off-angle distribution in the plurality of seed substrates.

## Description

### TECHNICAL FIELD

The present invention relates to a nitride semiconductor crystal and a production process thereof. More specifically, the present invention relates to a nitride semiconductor crystal having a large area and a small surface off-angle variation, and a production process thereof.

### BACKGROUND ART

A nitride semiconductor typified by gallium nitride (GaN) has a large band gap and involves a band-to-band transition of a direct transition type and therefore, this is a promising material as a substrate of a light emitting diode such as ultraviolet, blue or green light emitting diode, a light emitting element on a relatively short wavelength side, such as semiconductor laser, and a semiconductor device such as electronic device.

The nitride semiconductor has a high melting point, and the dissociation pressure of nitrogen near the melting point is high, making it difficult to cause bulk growth from a melt. On the other hand, it is known that a nitride semiconductor crystal can be produced using a vapor phase growth process such as hydride vapor phase epitaxy method (HVPE method) and metal-organic chemical vapor deposition method (MOCVD method).

In this connection, a nitride semiconductor crystal can be grown on an underlying substrate surface by disposing an underlying substrate on a support and supplying a raw material gas. The nitride semiconductor crystal grown on the underlying substrate can be taken out by separating it together with the underlying substrate from the support and, if desired, removing the underlying substrate by polishing or the like method (see, for example, Patent Document 1).

As the underlying substrate, many heterogeneous substrates such as sapphire and GaAs are used. The nitride semiconductor crystal grown on a heterogeneous substrate is subjected to warpage due to difference in the lattice constant or thermal expansion coefficient between the underlying substrate and the heterogeneous substrate. The warpage is known to be observed also in the nitride semiconductor free-standing crystal after removing the underlying substrate.

When the nitride semiconductor free-standing crystal is warped, an off-angle variation is produced on the surface of a semiconductor substrate prepared by processing the crystal. The "off-angle" as used herein means a tilt angle of the normal direction of the principal plane with respect to a low index plane.

If an off-angle variation is present on the nitride semiconductor substrate surface, when a semiconductor device is formed on the substrate, in the case of, for example, a light emitting device, the composition of the epitaxial layer may vary, giving rise to variation of the emission wavelength in the substrate plane.

In this way, production of an off-angle variation on the nitride semiconductor substrate surface is considered to affect the characteristics of a semiconductor device using the nitride semiconductor substrate and for suppressing the variation, various studies are being made.

In Patent Document 2, tilting of the growth direction of a gallium nitride crystal is described as a cause of the off-angle variation of a gallium nitride crystal on the gallium nitride substrate surface. A gallium nitride crystal grows while tilting to face the center of the underlying substrate.

Therefore, it is stated that even when the gallium nitride crystal is processed to let the crystal axis near the center of the gallium nitride substrate coincide with the normal line of the gallium nitride substrate surface, the crystal axis does not coincide with the normal line on the gallium nitride substrate surface in the vicinity of the substrate end part and an off-angle variation is produced in the gallium nitride substrate as a whole. In order to avoid this problem, a production process including processing to form a concavely spherical surface has been disclosed.

Meanwhile, as a technique for producing a nitride semiconductor substrate having a large area, a method of disposing at least two or more seed substrates and growing a crystal on the substrates, thereby obtaining a nitride semiconductor substrate having a large area, is described in Patent Documents 3 and 4.

In Patent Document 3, it is described that a plurality of nitride semiconductor seed substrates are disposed by arranging (0001) planes, (000-1) planes, or (0001) plane and (000-1) plane, of adjacent nitride semiconductor seed substrates to face each other and allowing a {10-10} plane of each nitride semiconductor seed substrate to work out to the top surface and a nitride semiconductor is again grown on the top surfaces of the nitride semiconductor seed substrates disposed, whereby a nitride semiconductor layer having a continuous {10-10} plane on the principal plane is formed and a {10-10} plane nitride semiconductor wafer with a large area is obtained.

In Patent Document 4, it is described that a plurality of nitride semiconductor seed substrates are prepared, these substrates are disposed to be adjacent to each other in the transverse direction while arranging the principal planes of the plurality of nitride semiconductor seed substrates to lie in parallel with each other and let the [0001] directions of their bars be the same and a nitride semiconductor is again grown on the top surfaces of the nitride semiconductor seed substrates disposed, whereby a nitride semiconductor layer having a continuous {10-10} plane on the principal plane is formed and a nitride semiconductor substrate is obtained.

### CONVENTIONAL ART

### Patent Document

Patent Document 1: JP-A-2006-240988 (the term "JP-A" as used herein means an "unexamined published Japanese patent application")
Patent Document 2: JP-A-2009-126727
Patent Document 3: JP-A-2006-315947
Patent Document 4: JP-A-2008-143772

### SUMMARY OF THE INVENTION

### Problems that the Invention is to Solve

However, the method described in Patent document 2 is a technique of merely processing the surface along with the crystal axis variation, thereby reducing the off-angle variation, and therefore, there may arise a problem when a device production process such as photolithography is performed using a substrate having a concave substrate surface.

Also, Patent Documents 3 and 4 are silent on the off-angle variation on the surface of the produced nitride semiconductor, and to what extent the crystal axis variation can be reduced is unknown.

Accordingly, an object of the present invention is to, with respect to a production process of a nitride semiconductor crystal, produce a nitride semiconductor crystal having a large area with a smaller surface off-angle variation than ever before. Another object of the present invention is to provide a nitride semiconductor substrate with a small off-angle variation by reducing the crystal axis variation as much as possible without using a special processing method.

### MEANS FOR SOLVING THE PROBLEMS

As a result of intensive studies made to attain the above-described objects, the present inventors have found that surprisingly, when a plurality of seed substrates differing in the off-angle are disposed and a single nitride semiconductor layer is grown thereon to obtain a nitride semiconductor crystal, the obtained nitride semiconductor crystal is reduced in the off-angle variation. The present invention has been accomplished based on this finding.

That is, the present invention includes the followings.
1. A production process for a nitride semiconductor crystal, comprising growing a semiconductor layer on a seed substrate to obtain a nitride semiconductor crystal, wherein said seed substrate contains a plurality of seed substrates made of the same material, at least one of said plurality of seed substrates differs in the off-angle from the other seed substrates, and a single semiconductor layer is grown by disposing said plurality of seed substrates, such that when said single semiconductor layer is grown on said plurality of seed substrates, the off-angle distribution in said single semiconductor layer becomes smaller than the off-angle distribution in said plurality of seed substrates.
2. The production process for a nitride semiconductor crystal as described in the item 1 above, wherein each of said plurality of seed substrates is composed of a hexagonal semiconductor, the growth plane is substantially {10-10} plane, and at least one of the plurality of seed substrates differs only in the off-angle in either the [0001] axis direction or the [11-20] axis direction from the other seed substrates.
3. The production process for a nitride semiconductor crystal as described in the item 1 above, wherein each of said plurality of seed substrates is composed of a hexagonal semiconductor, the growth plane is substantially {11-20} plane, and at least one of the plurality of seed substrates differs only in the off-angle in either the [0001] axis direction or the [10-10] axis direction from the other seed substrates.
4. The production process for a nitride semiconductor crystal as described in the item 1 above, wherein each of said plurality of seed substrates is composed of a hexagonal semiconductor, the growth plane is substantially (0001) plane or substantially (000-1) plane, and at least one of the plurality of seed substrates differs only in the off-angle in either the [10-10] axis direction or the [11-20] axis direction from the other seed substrates.
5. The production process for a nitride semiconductor crystal as described in the item 1 above, wherein each of said plurality of seed substrates is composed of a hexagonal semiconductor, the growth plane is substantially (0001) plane or substantially (000-1) plane, and at least one of the plurality of seed substrates differs in the off-angle in both the [10-10] axis direction and the [11-20] axis direction from the other seed substrates.
6. The production process for a nitride semiconductor crystal as described in the item 1 above, wherein each of said plurality of seed substrates is composed of a hexagonal semiconductor, the growth plane is substantially {10-10} plane, and at least one of the plurality of seed substrates differs in the off-angle in both the [11-20] axis direction and the [0001] axis direction from the other seed substrates.
7. The production process for a nitride semiconductor crystal as described in c the item 1 above, wherein each of said plurality of seed substrates is composed of a hexagonal semiconductor, the growth plane is substantially {11-20} plane, and at least one of the plurality of seed substrates differs in the off-angle in both the [10-10] axis direction and the [0001] axis direction from the other seed substrates.
8. The production process for a nitride semiconductor crystal as described in any one of the items 1 to 7 above, wherein said plurality of seed substrates are disposed while gradually changing the off angle, such that when a single crystal layer is grown on said plurality of seed substrates, the off-angle variation of said single semiconductor layer is reduced.
9. The production process for a nitride semiconductor crystal as described in any one of the items 1 to 8 above, wherein said plurality of seed substrates are disposed such that the off-angle is gradually changed along the way from near the center to the peripheral part of said plurality of seed substrates.
10. The production process for a nitride semiconductor crystal as described in any one of the items 1 to 9 above, wherein said plurality of seed substrates are disposed such that the crystallographic plane of said plurality of continuing seed substrates forms a convex shape.
11. The production process for a nitride semiconductor crystal as described in any one of the items 1 to 10 above, wherein said plurality of seed substrates are disposed such that the off-angle in an intermediate part of seed consisting of said plurality of seed substrates becomes smaller than the off-angle at both ends of said seed.
12. The production process for a nitride semiconductor crystal as described in any one of the items 1 to 11 above, wherein said plurality of seed substrates are disposed such that the off-angle directions of at least part of adjacent seed substrates out of said plurality of seed substrates become almost the same.
13. The production process for a nitride semiconductor crystal as described in any one of the items 1 to 12 above, wherein each of said plurality of seed substrates comprises at least one member selected from sapphire, SiC, ZnO and a Group III nitride semiconductor.
14. The production process for a nitride semiconductor crystal as described in any one of the items 1 to 13 above, wherein said single semiconductor layer is at least one member selected from gallium nitride, aluminum nitride, indium nitride and a mixed crystal thereof.
15. The production process for a nitride semiconductor crystal as described in any one of the items 1 to 14 above, wherein the single semiconductor layer is grown on said plurality of seed substrates by at least any one of an HVPE method, an MOCVD method, an MBE method, a sublimation method and a PLD method.
16. The production process for a nitride semiconductor crystal as described in any one of the items 1 to 15 above, wherein said plurality of seed substrates are a seed substrate produced by preparing a plurality of ingots made of the same material and cutting out, from each ingot, a portion having a smallest off-angle in said each ingot.
17. The production process for a nitride semiconductor crystal as described in any one of the items 1 to 16 above, wherein said plurality of seed substrates are a plurality of seed substrates which contain at least one seed substrate differing in the off-angle from the other seed substrates, and are produced by cutting-out from an ingot where the tilt angle of the crystal axis is changed along the way from near the center to the peripheral part.
18. The production process for a nitride semiconductor crystal as described in the item 16 or 17, wherein said ingot is produced by a semiconductor crystal production process of growing a semiconductor layer on a seed.
19. A Group III nitride semiconductor crystal produced by the production process claimed in any one of the items 1 to 18 above.
20. A Group III nitride semiconductor crystal having a principal plane except for a (0001) plane, wherein the off-angle distribution is 1° or less within a diameter of 2 inches.
21. A Group III nitride semiconductor crystal with a thickness of 100 µm to 5 cm, which has a principal plane inclined at an off-angle of 0 to 65° with respect to a {10-10} plane of a hexagonal crystal, and has a dislocation penetrating the surface of the principal plane, wherein the off-angle distribution in the [0001] axis direction of the [10-10] axis per 2 inches of said Group III nitride semiconductor crystal is within ±0.93°.
22. The Group III nitride semiconductor crystal as described in the item 20 or 21 above, wherein a region in which the amount of off-angle change per 1 mm of the crystal exceeds 0.015°, is present.
23. The Group III nitride semiconductor crystal as described in any one of the items 20 to 22 above, wherein a region in which the amount of off-angle change per 1 mm of the crystal exceeds 0.056°, is present.
24. The Group III nitride semiconductor crystal as described in any one of the items 20 to 23 above, wherein a region in which the amount of off-angle change per 1 mm of the crystal exceeds 0.03° is present plurally.
25. The Group III nitride semiconductor crystal as described in any one of the items 20 to 24 above, wherein the area of said principal plane is larger than 750 mm².
26. The Group III nitride semiconductor crystal as described in any one of the items 20 to 25 above, wherein the density of dislocations penetrating the surface of the principal plane is from 5×10⁵ to 2×10⁸ cm⁻².

### ADVANTAGE OF THE INVENTION

According to the production process of a nitride semiconductor crystal of the present invention, the off-angle of each seed substrate contained in a plurality of seed crystals is controlled and the plurality of seed crystals are disposed, whereby the off-angle of a single crystal layer grown on the plurality of seed substrates can be controlled and the off-angle variation in the produced nitride semiconductor crystal can be reduced much more than ever before.

### BRIEF DESCRIPTION OF THE DRAWINGS

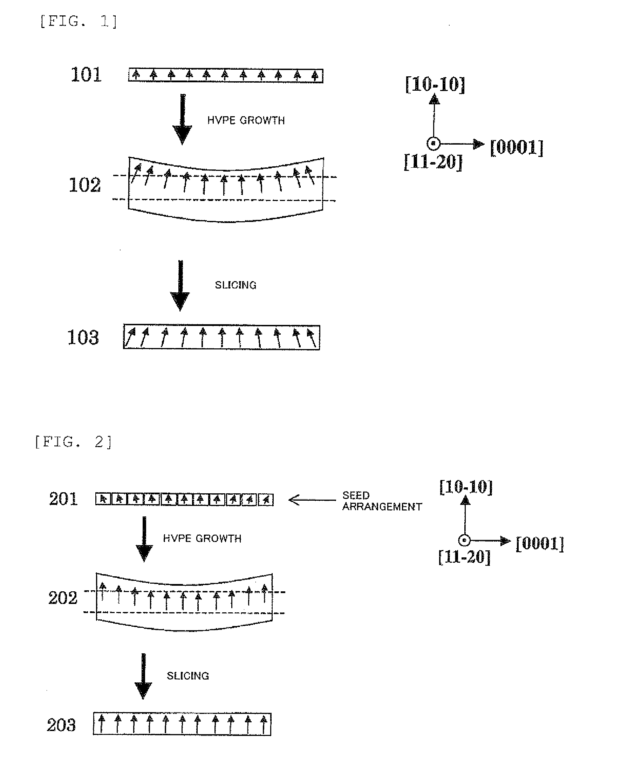

[Fig. 1] A schematic view for explaining the tilt of the crystal axis of a nitride semiconductor crystal obtained when a semiconductor layer is grown on a seed substrate having aligned off-angles.
[Fig. 2] A schematic view for explaining the tilt of the crystal axis of a nitride semiconductor obtained when a semiconductor layer is grown on a seed substrate to which the process of the present invention is adapted.

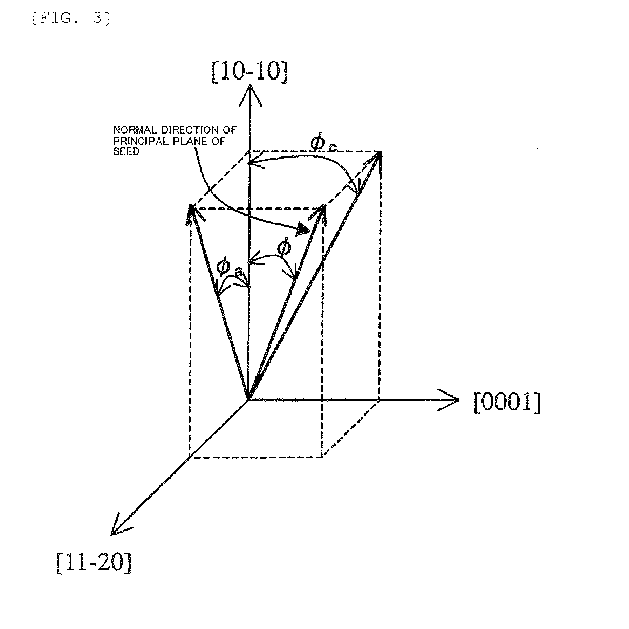

[Fig. 3] A schematic view for explaining the off-angle.

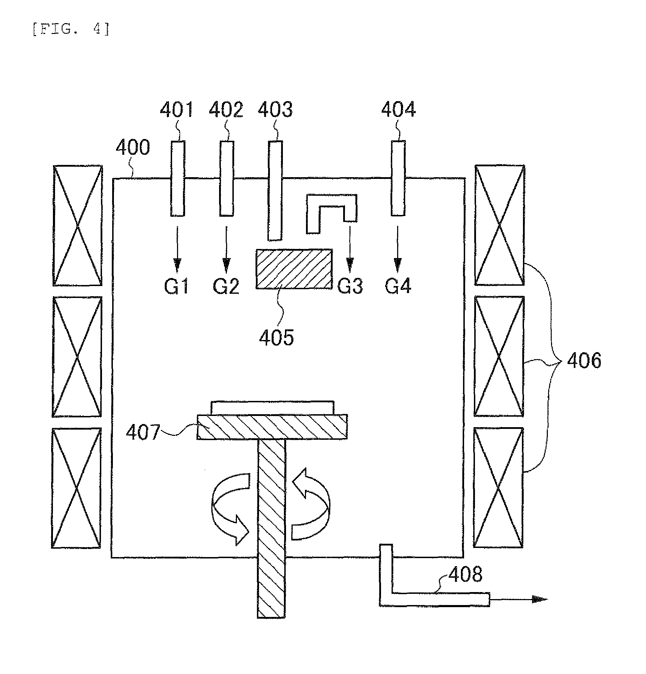

[Fig. 4] A diagrammatic view of an HVPE apparatus.

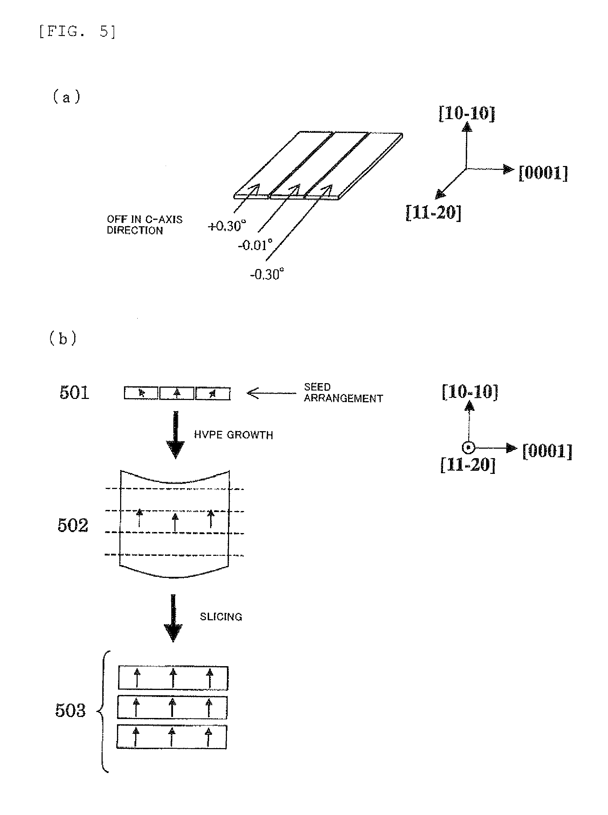

[Fig. 5] Fig. 5(a) is a schematic view for explaining the method for disposing (10-10) plane gallium nitride seed substrates in Example 1, and Fig. 5(b) is a schematic view for explaining the tilt of the crystal axis of the nitride semiconductor crystal according to the present invention in Example 1.

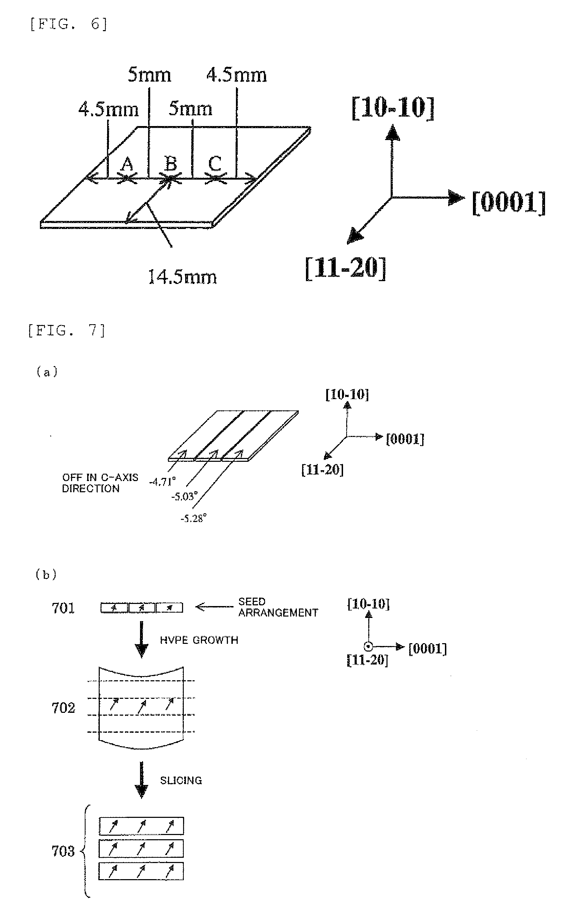

[Fig. 6] A schematic view for explaining the portions in which the off angle is measured in Example 1 to 3 and Comparative Examples 1 to 4.
[Fig. 7] Fig. 7(a) is a schematic view for explaining the method for disposing (10-10) plane gallium nitride seed substrates in Example 2, and Fig. 7(b) is a schematic view for explaining the tilt of the crystal axis of the nitride semiconductor crystal according to the present invention in Example 2.

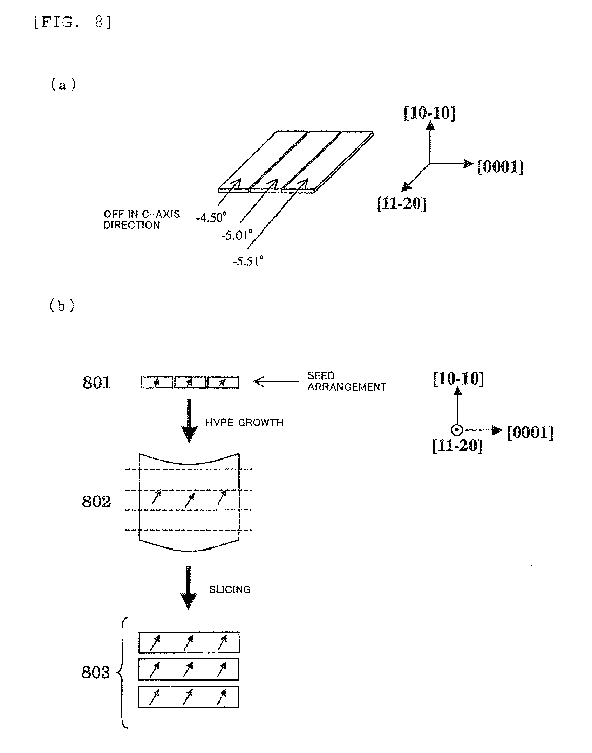

[Fig. 8] Fig. 8(a) is a schematic view for explaining the method for disposing (10-10) plane gallium nitride seed substrates in Example 3, and Fig. 8(b) is a schematic view for explaining the tilt of the crystal axis of the nitride semiconductor crystal according to the present invention in Example 3.

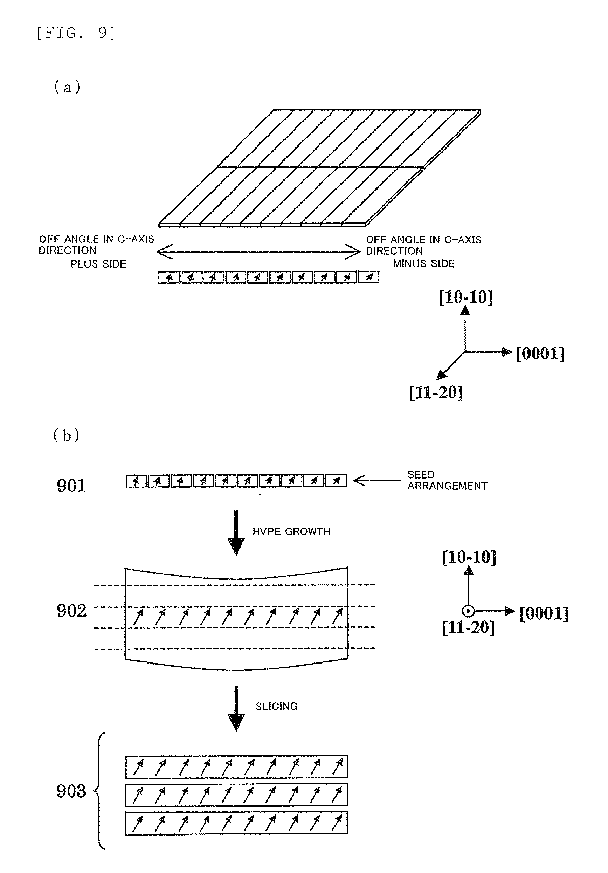

[Fig. 9] Fig. 9(a) is a schematic view for explaining the method for disposing (10-10) plane gallium nitride seed substrates in Example 4, and Fig. 9(b) is a schematic view for explaining the tilt of the crystal axis of the nitride semiconductor crystal according to the present invention in Example 4.

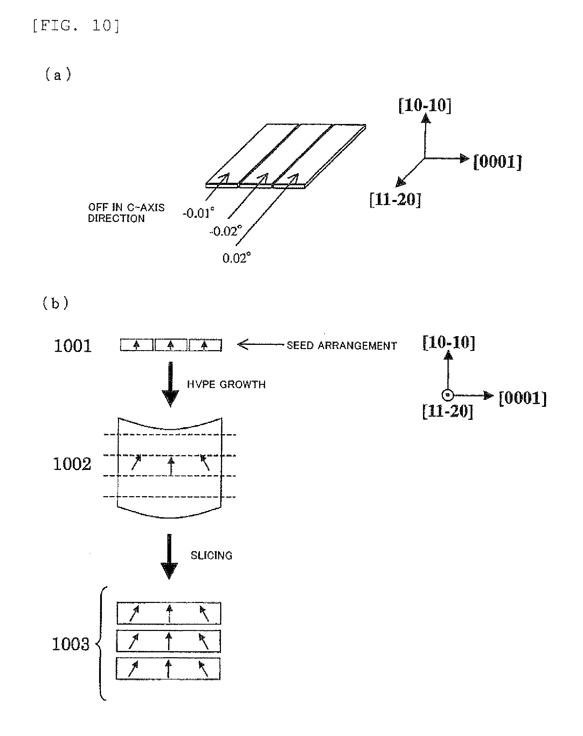

[Fig. 10]Fig. 10(a) is a schematic view for explaining the method for disposing (10-10) plane gallium nitride seed substrates in Comparative Example 1, and Fig. 10(b) is a schematic view for explaining the tilt of the crystal axis of the nitride semiconductor crystal according to the present invention in Comparative Example 1.

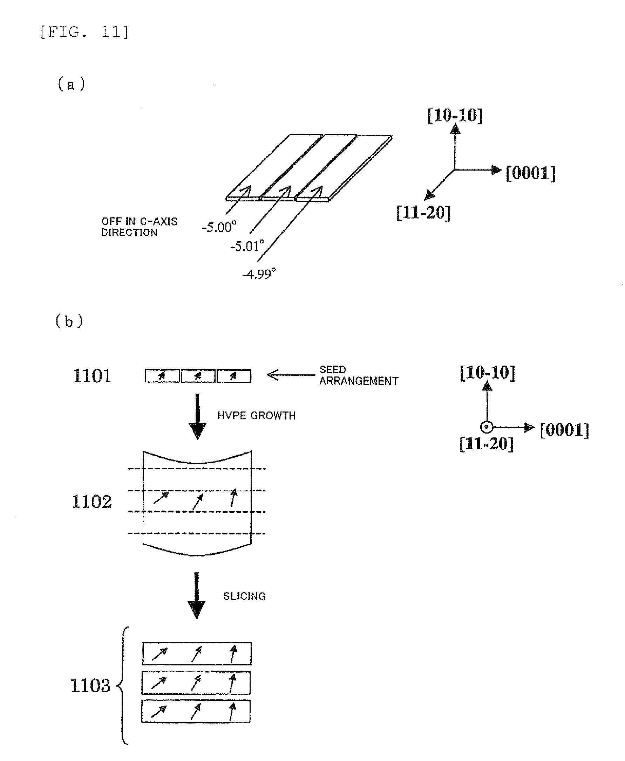

[Fig. 11]Fig. 11(a) is a schematic view for explaining the method for disposing (10-10) plane gallium nitride seed substrates in Comparative Example 2, and Fig. 11(b) is a schematic view for explaining the tilt of the crystal axis of the nitride semiconductor crystal according to the present invention in Comparative Example 2.

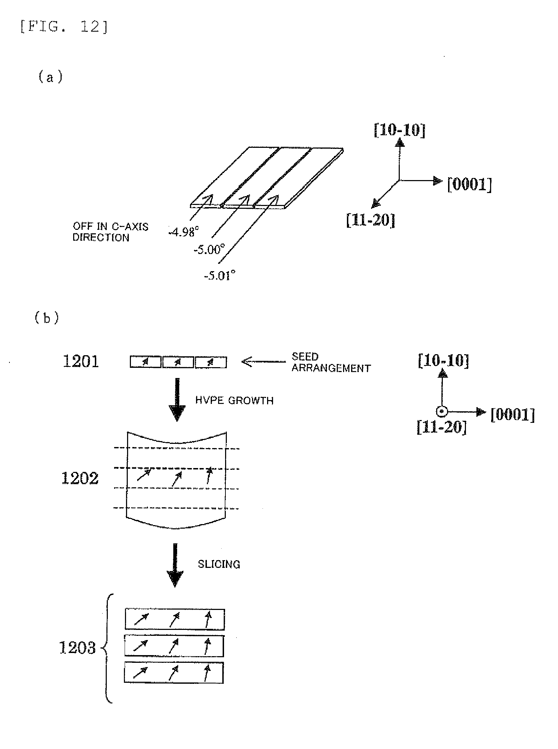

[Fig. 12]Fig. 2(a) is a schematic view for explaining the method for disposing (10-10) plane gallium nitride seed substrates in Comparative Example 3, and Fig. 12(b) is a schematic view for explaining the tilt of the crystal axis of the nitride semiconductor crystal according to the present invention in Comparative Example 3.

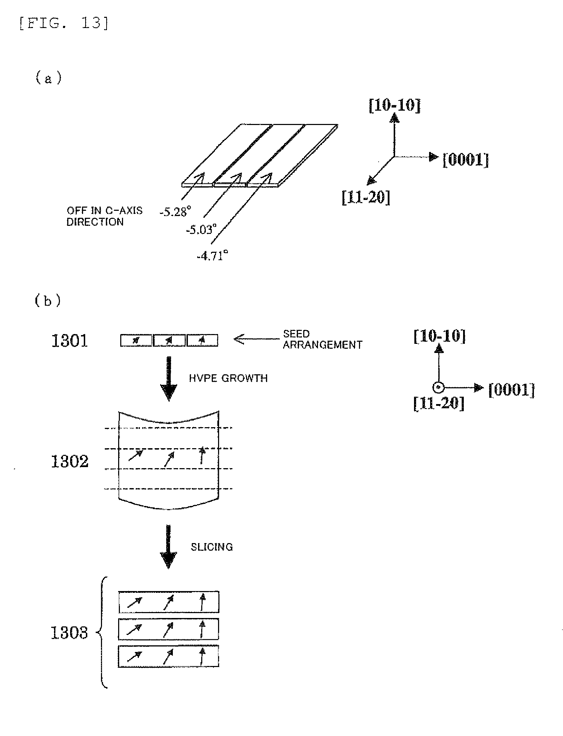

[Fig. 13]Fig. 13(a) is a schematic view for explaining the method for disposing (10-10) plane gallium nitride seed substrates in Comparative Example 4, and Fig. 13(b) is a schematic view for explaining the tilt of the crystal axis of the nitride semiconductor crystal according to the present invention in Comparative Example 4.

### MODE FOR CARRYING OUT THE INVENTION

The production process of the nitride semiconductor crystal of the present invention is described in detail below. In the following, the constituent requirements are described based on representative embodiments of the present invention, but the present invention is not limited to those embodiments.

Also, in the following, the nitride semiconductor crystal is described by taking a gallium nitride as an example, but the nitride semiconductor crystal which can be employed in the present invention is not limited thereto.

Incidentally, in the description of the present invention, the numerical value range indicated using "from (numerical value) to (numerical value)" means a range including the numerical values before and after "to" as the lower limit value and the upper limit value, respectively.

### (Material, Lattice Constant and Thermal Expansion Coefficient of Seed Substrate)

The seed substrate is not limited in its kind as long as a desired nitride semiconductor crystal can be grown on the crystal growth plane. Also, the seed substrate may be used as an underlying substrate for crystal growth. The nitride semiconductor crystal is a hexagonal semiconductor and therefore, the seed substrate is preferably composed of a hexagonal semiconductor.

Examples of the material for the seed substrate include sapphire, SiC, ZnO and a Group III nitride semiconductor. Among these, a Group III nitride semiconductor is preferred, a nitride semiconductor containing the same kind of a Group III element as the nitride semiconductor to be produced is more preferred, and the same kind of a nitride semiconductor as the nitride semiconductor to be produced is still more preferred.

Each seed substrate contained in the plurality of seed substrates is composed of the same material. The term "the same material," as used herein indicates that the material has the same chemical properties and the quality of the material is the same. By using the same material for each seed substrate contained in the plurality of seed substrates, the characteristic distribution of the produced nitride semiconductor crystal can be uniformized.

The lattice constant of the seed substrate is preferably a value close to the lattice constant of the nitride semiconductor crystal to be produced, because generation of a defect due to lattice mismatch can be prevented. The difference in the lattice constant between the nitride semiconductor crystal to be produced and the seed substrate is preferably within 17%, more preferably within 5%, based on the lattice constant of the nitride semiconductor crystal.

The thermal expansion coefficient of the seed substrate is preferably a value close to the thermal expansion coefficient of the nitride semiconductor crystal to be produced, because generation of warpage due to difference in the thermal expansion coefficient can be prevented. The absolute value of the difference in the thermal expansion coefficient between the nitride semiconductor crystal to be produced and the seed substrate is preferably within 2×10⁻⁶/°C or less, more preferably 1×10⁻⁶/°C or less.

### (Shape of Seed Substrate)

The shape of the seed substrate is not particularly limited as long as the essence of the present invention is observed, but a seed substrate having a so-called tapered shape may be used. Also, when the plurality of seed substrates have the same shape, this advantageously makes it easy to dispose a large number of seed substrates. The shape of the principal plane of the seed substrate may be a polygonal shape, and a rectangular or square shape may be also preferably used.

The one-side length of the principal plane of the seed substrate is preferably 5 mm or more, more preferably 15 mm or more, still more preferably 20 mm or more. By setting the one-side length of the principal plane of the seed substrate to 5 mm or more, the number of seed substrates prepared can be reduced when producing a nitride semiconductor crystal having a large area.

Also, by using a seed substrate where the one-side length of the principal plane is 5 mm or more, precision in aligning the orientations of the seed substrates disposed can be enhanced, and the length above is preferred also from the standpoint that the seed substrate can be reduced in the bonding plane which is liable to incur impairment of the crystallinity.

Here, the "principal plane of the seed substrate" as used in the present invention indicates a widest plane in the seed substrate.

### (Plane Orientation of Seed Substrate)

In crystallography, notation such as (hkl) or (hkil) is used to indicate a plane orientation of the crystal surface. The plane orientation of the crystal surface in a hexagonal crystal such as Group III nitride crystal is represented by (hkil).

Here, h, k, i and 1 are integers called Miller index and have a relationship of i=-(h+k). The plane of this plane orientation (hkil) is referred to as a (hkil) plane. Also, the {hkil} plane generically means a plane orientation including the (hkil) plane and individual plane orientations crystallographically equivalent thereto.

The plane orientation of the principal plane of the seed substrate includes a polar plane such as (0001) plane and (000-1) plane, a nonpolar plane such as {1-100} plane and {11-20} plane, and a semipolar plane such as {1-102} plane and {11-22} plane.

In the case of a seed substrate having a rectangular shape, in view of easy control of the crystal growth, the principal plane of the seed substrate is preferably a {10-10} plane, a {11-20} plane, a {10-1-1} plane or a {20-2-1} plane, more preferably a {10-10} plane. Also, the plane orientations of four side surfaces are preferably a (0001) plane, a (000-1) plane, a {11-20} plane and a {11-20} plane, or a (0001) plane, a (000-1) plane, a {10-10} plane and {10-10} plane, more preferably a (0001) plane, a (000-1) plane, a {11-20} plane and a {11-20} plane.

### (Area of Principal Plane of Seed Substrate)

The area of the principal plane of the seed substrate containing a plurality of seed substrates is preferably larger and is preferably 50 mm² or more, more preferably 75 mm² or more, still more preferably 100 mm² or more.

By setting the area of the principal plane of the seed substrate to 50 mm² or more, the number of seed substrates prepared can be more reduced. Also, the number of bonding planes can be reduced, so that the twist angle distribution in the nitride semiconductor crystal grown on the seed substrate can be kept from increasing. The term "twist angle" indicates the orientation distribution (in-plane orientation distribution) of crystal axes in the direction parallel to the principal plane.

### (Angle Between Bonding Plane and Principal Plane)

The "bonding plane" indicates respective planes of seed substrates, which become adjacent to each other when disposing a plurality of seed substrates. The angle between the bonding plane and the principal plane is not particularly limited but in view of easy processing for preparing a seed substrate, a substantially right angle is preferred. The angle between the bonding plane and the principal plane is preferably from 88 to 92°, more preferably from 89 to 91°, still more preferably from 89.5 to 90.5°.

### (Expression Method of Off-Angle)

Fig. 3 is a schematic view showing the relationship between the normal direction of the principal plane of the seed substrate and the crystal axis direction of the seed substrate so as to explain the tilt (off-angle) of the normal direction of the principal plane with respect to a low index plane. In Fig. 3, a case where the low index plane for the principal plane is a (10-10) plane and the bonding planes are a (0001) plane and a (11-20) plane is envisaged. Incidentally, the off-angle of the seed substrate can be measured by the X-ray analysis method.

The angle between the normal direction of the principal plane of the seed substrate and the [10-10] axis is assumed to be φ, the angle between the [10-10] axis and the projection axis when the normal line of the principal plane of the seed substrate is projected on a plane defined by the [10-10] axis and the [0001] axis is assumed to be φc, and the angle between the [10-10] axis and the projection axis when the normal line of the principal plane of the seed substrate is projected on a plane defined by the [10-10] axis and the [11-20] axis is assumed to be φa.

In the case shown in Fig. 3, it can be expressed that the normal direction of the principal plane of the seed substrate is inclined at φc in the [0001] direction and inclined at φa in the [11-20] direction, with respect to the low index plane for the principal plane, that is, the (10-10) plane.

Here, the [hkil] direction indicates the direction perpendicular to the (hkil) plane (the normal direction of the (hkil) plane), and the <hkil> direction generically means a direction including the [hkik] direction and individual directions crystallographically equivalent thereto.

### (Tilt of Normal Direction of Bonding Plane with Respect to Low Index Plane)

The normal direction of the bonding plane may or may not inclined with respect to the low index plane. However, considering the easiness in disposing seed substrates and the twist angle distribution in the crystal after bonding, the difference between tilts with respect to the low index plane in respective axis directions of two opposing bonding planes is preferably smaller. Accordingly, the difference between tilts with respect to the low index plane in respective axis directions of two opposing bonding planes is preferably within 1 °, more preferably within 0.7°, still more preferably 0.5° or less.

For example, the bonding plane facing the bonding plane where the normal direction of the bonding plane is inclined at +5° in the [11-20] direction and at +5° in the [10-10] direction with respect to the (0001) plane is preferably a bonding plane where the normal direction of the boding plane is inclined at +5° in the [11-20] direction and +5° in the [10-10] direction with respect to the (000-1) plane.

Also, the absolute value distribution of tilts with respect to the low index plane in respective axis directions between the seed substrates is preferably within 1°, more preferably within 0.7°, still more preferably within 0.5°. Because, when the absolute value distribution of tilts with respect to the low index plane in respective axis directions between the seed substrates is within 1°, the bonding planes can be caused to almost parallelly face each other and the twist angle distribution in the crystal after bonding can be reduced.

### (Cutting-Out of Principal Plane and Cutting-Out Method)

The seed substrate having a desired plane can be obtained by cutting an ingot, if desired. For example, a Group III nitride semiconductor ingot having a (0001) plane is formed and then cut to expose a {10-10} plane or a {11-20} plane, whereby a seed substrate having a {10-10} plane or a {11-20} plane as the principal plane can be obtained.

The plurality of seed substrates are preferably obtained by preparing a plurality of ingots made of the same material and cutting out, from each ingot, a portion having a smallest off-angle distribution in the each ingot. By this cutting-out, the off-angle distribution in the seed substrate can be reduced.

The method for preparing a plurality of seed substrates with at least one seed substrate, out of the plurality of seed substrates, differing in the off-angle from other seed substrates is preferably a method of cutting out the seed substrate from an ingot where the off-angle is gradually changed along the way from near the center to the peripheral part, that is, from the inner side to the outer side. However, for reducing the off-angle variation in each seed substrate, it is preferred to cut out only a portion having a smallest off-angle variation in the ingot.

The cutting-out method includes, for example, a method of processing the ingot with a file, a grinding machine, an inner periphery blade slicer, a wire saw or the like (grinding and slicing), a method of polishing the ingot by abrasion, and a method of dividing the ingot by cleavage. Above all, the {10-10} plane or {11-20} plane is preferably formed by cleavage.

As for the cleaving method, the ingot may be broken by putting notches with a diamond scriber, or a laser scriber device may be used. The ingot may be broken directly with a hand or may be placed on another base and broken using a breaking device.

The degree of parallelism between the front and back surfaces of the seed substrate is preferably within 1°, more preferably within 0.7°, still more preferably within 0.5°. When the degree of parallelism of the seed substrate is within 1°, a problem that the processing such as grinding is difficult to perform can be prevented from occurring.

The ingot is preferably an ingot created by a semiconductor crystal production process of growing a semiconductor layer on a seed. The semiconductor crystal production process includes, for example, an HVPE method.

### (Method for Disposing Seed Substrates)

In the production process of the present invention, a plurality of seed substrates are disposed and a single semiconductor layer is grown on the plurality of seed substrates. The term "single semiconductor layer" as used herein indicates one integral semiconductor layer.

The plurality of seed substrates are disposed such that when a single semiconductor layer is grown on the plurality of seed substrates, the off-angle distribution in the single semiconductor layer becomes smaller than the off-angle distribution in the plurality of seed substrates. By disposing the seed substrates in this way, a nitride semiconductor crystal having a small off-angle distribution can be produced.

The term "off-angle distribution" as used herein indicates an off-angle variation in the principal plane and can be determined by performing X-ray diffraction measurement at a plurality of points in the principal plane. The difference between the off-angle distribution in the single semiconductor layer and the off-angle distribution in the plurality of seed substrates is preferably a difference of 10% or more, more preferably a difference of 20 to 2,000%, based on the off-angle distribution in the single semiconductor layer.

Incidentally, the plurality of seed substrates may be disposed to become adjacent to each other on the same plane or may be disposed to overlap and become adjacent to each other in a planar manner.

In the production process of the present invention, a plurality of seed substrates with at least one seed substrate, out of the plurality of seed substrates, differing in the off-angle from other seed substrates are used. Thanks to this configuration, the crystallographic plane shape of the plurality of continuing seed substrates can be controlled.

For example, in the case where each of the plurality of seed substrates is composed of a hexagonal semiconductor and the growth plane is substantially {10-10} plane, at least one seed substrate out of the plurality of seed substrates preferably differs in at least one off-angle in the [0001] axis direction or the [11-20] axis direction from other seed substrates.

In the case where each of the plurality of seed substrates is composed of a hexagonal semiconductor and the growth plane is substantially {11-20} plane, at least one seed substrate out of the plurality of seed substrates preferably differs in at least one off-angle in the [0001] axis direction or the [10-10] axis direction from other seed substrates.

In the case where each of the plurality of seed substrates is composed of a hexagonal semiconductor and the growth plane is substantially (0001) plane or substantially (000-1) plane, at least one seed substrate out of the plurality of seed substrates preferably differs in at least one off-angle in the [10-10] axis direction or the [11-20] axis direction from other seed substrates.

The substantially {10-10} plane, the substantially {11-20} plane, the substantially (0001) plane and the substantially (000-1} plane means that in the plurality of substrates, respective growth planes are aligned in the direction of {10-10} plane, {11-20} plane, (0001) plane or (000-1) plane within an off-angle misalignment of about ±10°_{.}

The plurality of seed substrates are preferably disposed such that the off-angle is gradually changed along the way from near the center to the peripheral part. By disposing the plurality of seed substrates in this way, the crystallographic plane shape of the plurality of continuing seed substrates can be controlled.

Here, the expression that the off-angle of the seed substrate is gradually changed "along the way from near the center to the peripheral part" indicates that the off-angle of the seed substrate is gradually changed along the way from the inner side to the outer side of the seed substrate containing a plurality of seed substrates.

Depending on the semiconductor crystal structure, warpage from near the center does not uniformly occur in every directions and therefore, the amount of off-angle change needs to be determined by taking into consideration the semiconductor crystal structure. Specifically, for example, when a {10-10} plane grows a surface gallium nitride layer on a seed substrate composed of gallium nitride with the growth plane being the {10-10} plane, since warpage in the [0001] axis direction is extremely large compared with other directions, it is preferred to gradually change the off-angle of the seed substrate along the way from the inner side to the outer side only in the [0001] axis direction.

Furthermore, depending on the structure of the semiconductor crystal production apparatus, the temperature distribution inside the semiconductor crystal production apparatus is sometimes greatly biased to largely shift the warpage center of the grown semiconductor layer from near the center of the seed substrate.

In this case, by taking into consideration the warpage center and the warpage amount in each portion of the grown single semiconductor layer, the seed substrates are preferably disposed to let the off-angle be gradually changed along the way from the inner side to the outer side around one arbitrary seed substrate contained in the plurality of seed substrates so that the off-angle variation in the single semiconductor layer can be smaller than the off-angle variation in the plurality of seed substrates.

In the case above, the difference between the off-angle variation in the single semiconductor layer and the off-angle variation in the plurality of seed substrates is preferably a difference of 10% or more, more preferably a difference of 20 to 2,000%. Within this range, the amount of curvature change can be made the same on the crystal plane of the seed substrate group consisting of a plurality of seed substrates and on the crystal plane of the growing single semiconductor layer. Incidentally, the off-angle variation can be determined by X-ray diffraction measurement.

Specifically, for example, the plurality of seed substrates are preferably disposed such that the crystallographic plane of the plurality of continuing seed substrates forms a convex shape. Thanks to this configuration, the off-angle distribution of the produced nitride semiconductor crystal can be reduced by utilizing the change in the curvature of the crystal plane of the growing gallium nitride single crystal film.

In another specific example, when producing a nitride semiconductor crystal having a principal plane close to a low index plane, the seed substrates are preferably disposed such that the off-angle in the intermediate part of the seed consisting of the plurality of seed substrates becomes smaller than the off-angle at both ends of the seed, and more preferably disposed such that the off-angle is continuously increased along the way from a portion having a smallest off-angle in the intermediate part to both ends. Thanks to such a configuration, the off-angle distribution of the produced nitride semiconductor crystal having a principal plane close to a low index plane can be reduced by utilizing the change in the curvature of the crystal plane of the growing single semiconductor layer.

The term "seed" as used herein indicates the entirety of a single structure formed by disposing a plurality of seed substrates. The portion sandwiched by the opposing end parts of the seed is referred to as the intermediate part of the seed. Accordingly, the intermediate part indicates not the central part connecting both ends of the seed but the entire portion sandwiched by both ends of the seed.

In another preferred specific example, the seed substrates are preferably disposed such that the off-angle directions of at least part of adjacent seed substrates out of the plurality of seed substrates become almost the same, and the absolute value of the difference between the off-angle directions is preferably from 0.3 to 2.0°, more preferably from 0.5 to 1.5°. The off-angle directions of adjacent seed substrates are almost the same, the dislocation likely to be produced in the crystal grown above the bonded part of seed substrates can be advantageously reduced.

That is, when the normal direction of the principal plane of the seed substrate coincides with the orientation of the low index plane, the growth in the normal direction of each plane of the seed substrate becomes dominant. In this case, in the bonded part, lateral growth parts from adjacent seed substrates meet each other on the gap. This meeting part on the gap involves generation of a large amount of dislocations, similarly to the meeting part of ELO.

The growth is allowed to proceed in a state of having an appropriate tilt (off-angle) of the normal direction of the principal plane with respect to the low index plane, whereby a low index plane inclined from the principal plane is generated. This plane grows obliquely with respect to the principal plane while keeping the low index plane. In the case where an off-angle is formed in the normal direction of the bonding plane, the low index plane obliquely grows on the bonding part from one seed substrate and reaches a neighboring seed substrate, and the resultant meeting on the neighboring seed substrate can suppress the generation of a large amount of dislocations.

The absolute value of the off-angle of the seed substrate is preferably 0.1° or more, more preferably 1° or more, still more preferably 3° or more. When the absolute value of the off-angle of the seed substrate is 0.1° or more, lateral growth parts from both of adjacent seed substrates can be prevented from meeting on the gap before the growth part of the low index plane of one seed substrate traverses across the gap.

On the other hand, the absolute value of the off-angle of the seed substrate is preferably 15° or less, more preferably 10° or less, still more preferably 7° or less. When the absolute value of the off-angle of the seed substrate is 15° or less, an increase in the surface step density can be suppressed, and a problem that a step punching (generation of coarse and fine steps) readily occurs can be prevented.

Fig. 1 is a cross-sectional view of a nitride semiconductor crystal view for schematically showing how the growth proceeds on a seed substrate having aligned off-angles and not only the crystal itself is concavely warped but also the crystal plane is concavely curved.

In Fig. 1,101 indicates a seed substrate with the crystal axes being aligned, 102 indicates a nitride semiconductor crystal produce by growing it on the seed substrate 101, and 103 indicates the state of a substrate obtained by slicing the nitride semiconductor crystal 102 at dashed-line portions.

When a crystal is grown on the seed substrate 101 with the crystal axes being aligned, the produced nitride semiconductor crystal 102 is warped and in turn, the tilt angle of the crystal axis varies such that the tilt of the crystal axis inside the nitride semiconductor crystal 102 is increased along the way from near the center to the periphery.

Heretofore, such a nitride semiconductor crystal 102 is sliced at dashed-line portions and used as a nitride semiconductor substrate 103, but since the tilts of crystal axes inside the nitride semiconductor substrate 103 are not aligned, fabrication of, for example, a light emitting device by using such a nitride semiconductor substrate 103 faces a problem of variation in the emission wavelength as described above.

Fig. 2 shows the case where a single nitride semiconductor crystal is grown on a plurality of seed substrates by the production process of the present invention.

In Fig. 2, 201 indicates a seed substrate having a configuration where a plurality of seed substrates differing in the tilt of the crystal axis are disposed to let the crystal axis of each seed substrate radially extend from the back surface side to the front surface side and increase tilting along the way from near the center to the periphery. 202 indicates a nitride semiconductor crystal produced by growing it on the seed substrate 201, and 203 indicates how the nitride semiconductor crystal 202 is cut at dashed-line portions to make a substrate.

Also in the case shown in Fig. 2, similarly to the case shown in Fig. 1, the produced nitride semiconductor crystal 202 is warped, but the crystal axis inside the nitride semiconductor crystal 202 is kept from tilting by the action of the crystal axis of the seed substrate 201 and therefore, when the nitride semiconductor crystal 202 is sliced at the dashed-line portions, a nitride semiconductor substrate 203 free from variation in the tilt of the crystal axis can be produced.

Also, in the case shown in Fig. 2, depending on the crystal grown on the seed substrate, contrary to the case shown in Fig. 1, the crystal may be convexly warped, but in this case, when the seed substrate 201 shown in Fig. 2 is configured such that the plurality of substrates differing in the tilt of the crystal axis are disposed to let the crystal axis of each seed substrate radially extend from the front surface side to the back surface side and increase tilting along the way from near the center to the periphery, a semiconductor substrate with the crystal axes being aligned can be produced.

### (Amount of Off-Angle Change Between Seed Substrates)

The "amount of off-angle change between seed substrates" indicates an amount of off-angle change between respective seed substrates contained in the seed substrate produced by disposing a plurality of seed substrates such that the off-angle of each seed substrate is gradually changed along the way from near the center to the periphery.

The preferred range of the amount of off-angle change between seed substrates varies depending on the length of the single semiconductor layer or semiconductor crystal film grown on the plurality of seed substrates, but usually, the amount of off-angle change per unit length between the seed substrates produced by disposing a plurality of seed substrates is preferably 0.02°/mm or more, more preferably 0.03°/mm or more, still more preferably 0.05°/mm or more.

When the amount of off-angle change per unit length between seed substrates containing a plurality of seed substrate is 0.02°/mm or more, the amount of curvature change on the crystal plane of the seed substrate group consisting of a plurality of seed substrates can be prevented from becoming larger than on the crystal plane of the semiconductor crystal film growing on the plurality of seed substrates and the amount of off-angle change in the produced nitride semiconductor crystal can be reduced.

Also, usually, the amount of off-angle change per unit length between seed substrates containing a plurality of seed substrates is preferably 0.5°/mm or less, more preferably 0.3°/mm or less, still more preferably 0.2°/mm or less.

When the amount of off-angle change per unit length between seed substrates containing a plurality of seed substrates is 0.5°/mm or less, the amount of curvature change on the crystal plane of the seed substrate group consisting of a plurality of seed substrates can be prevented from becoming larger than on the crystal plane of the semiconductor crystal film growing on the plurality of seed substrates and the amount of off-angle change in the produced nitride semiconductor crystal can be reduced.

The amount of off-angle change between seed substrates is preferably adjusted such that the amount of curvature change is the same on the crystal plane of the seed substrate group consisting of a plurality of seed substrates and on the crystal plane of the growing single semiconductor layer. Because, the off-angle distribution in the produced nitride semiconductor crystal can be thereby reduced.

The "amount of curvature change on the crystal plane" as used herein indicates the degree of change in the curvature of the crystallographic plane shape of a plurality of continuing seed substrates during the growth of a nitride semiconductor and can be calculated by measuring the warpage in the shape of the produced nitride semiconductor.

For example, when the seed substrate group has a convex crystallographic plane shape and an off-angle distribution of 1.0° and the produced nitride semiconductor crystal has a concave crystallographic plane shape and an off-angle distribution of 0.5°, the amount of curvature change on the crystal plane is 1.5°.

The amount of curvature change on the crystal plane of the seed substrate group consisting of a plurality of seed substrates and on the crystal plane of the growing semiconductor crystal plane is preferably from 0.1 to 5.0°, more preferably from 0.5 to 5.0°.

If the amount of off-angle change between seed substrates is too small, the amount of curvature change on the crystal plane of the growing semiconductor crystal plane becomes larger than on the crystal plane of the seed substrate group consisting of a plurality of seed substrates, and the amount of off-angle change in the produced nitride semiconductor crystal cannot be reduced.

Specifically, for example, in the case of growing a gallium nitride single crystal film to a length of at least 0.3 mm or more, the amount of off-angle change per unit length of the seed substrate containing a plurality of seed substrates is preferably ±0.005°/mm or more, more preferably ±0.007°/mm or more, still more preferably ±0.01°/mm or more.

Specifically, for example, in the case of growing a Gallium nitride single crystal film to a length of at least 0.3 mm or more on a (10-10) plane gallium nitride seed substrate produced by arranging seed substrates differing in the off-angle in an area corresponding to a diameter of at least 2 inches, the amount of off-angle change between seed substrates in the C-axis ([0001]] axis) direction for a width of 2 inches is preferably ±0.25° or more, more preferably ±0.35° or more, still more preferably ±0.5° or more.

If the amount of off-angle change between seed substrates is too large, the amount of curvature change on the crystal plane of the seed substrate group becomes larger than on the crystal plane of a gallium nitride single crystal film during the growth of the gallium nitride single crystal film, and the amount of off-angle change cannot be reduced.

In the case of growing a gallium nitride single crystal film to a length at least 0.3 mm or more, the amount of off-angle change per unit length is preferably ±0.04°/mm or less, more preferably ±0.03°/mm or less, still more preferably ±0.02°/mm or less.

Specifically, for example, in the case of growing a gallium nitride single crystal film to a length of at least 0.3 mm or more on a (10-10) plane gallium nitride seed substrate produced by arranging seed substrates differing in the off-angle in an area corresponding to a diameter of at least 2 inches, the amount of off-angle change between seed substrates in the C-axis ([0001]] axis) direction is preferably ±2° or less, more preferably ±1.5° or less, still more preferably +1.0° or less.

In the production process of the present invention, use of a plurality of seed substrates is advantageous in that an arbitrary off-angle distribution can be created in the seed substrate containing a plurality of seed substrates. In the case where the amount of off-angle change in the plane of the semiconductor crystal grown on the seed substrate is varied, for example, in the case where the warpage is small on the inner circumference side of the semiconductor crystal but the warpage is large on the outer circumference side, it is effective to use a seed substrate containing a plurality of seed substrates.

### (Production Apparatus)

In the present invention, a raw material gas is supplied to the seed substrate, whereby a plate-like crystal is grown in the direction perpendicular to the crystal growth plane of the seed substrate. Examples of the growth method include a mental-organic chemical vapor deposition method (MOCVD method), a hydride vapor phase epitaxy method (HVPE method), a molecular beam epitaxy method (MBE method), a sublimation method, and a pulsed laser deposition method (PLD method), and an HVPE method is preferred because of a high growth rate.

Fig. 4 is a view for explaining a configuration example of the nitride semiconductor crystal production apparatus used in the present invention, but details of the configuration are not particularly limited. The HVPE apparatus shown in Fig. 4 comprises a susceptor 407 for placing a seed substrate in a reactor 400 and a reserver 405 for charging a raw material of the nitride semiconductor to be grown.

Also, inlet tubes 401 to 404 for introducing a gas into the reactor 400 and an exhaust tube 408 for discharging the gas are provided. Furthermore, a heater 406 for heating the reactor 400 from the side surface is provided.

### (Material of Reactor)

The material of the reactor 400 includes, for example, quartz, sintered boron nitride and stainless steel. The material is preferably quartz.

### (Gas Species of Atmosphere Gas)

In the reactor 400, an atmosphere gas is previously filled before start of the reaction. Examples of the atmosphere gas (carrier gas) include an inert gas such as hydrogen, nitrogen, He, Ne and Ar. A mixture of these gases may be also used.

### (Material and Shape of Susceptor and Distance from Growth Plane to Susceptor)

The material of the susceptor 407 is preferably carbon, and a material whose surface is coated with SiC is more preferred.

The shape of the susceptor 407 is not particularly limited as long as the seed substrate for use in the present invention can be disposed, but a shape not allowing a structure to be present near the crystal growth plane during the crystal growth is preferred. If a structure having a possibility of growing is present near the crystal growth plane, a polycrystal attaches thereto and an HCl gas is generated as a product and adversely affects the crystal to be grown.

The contact face between the seed substrate and the susceptor 407 is preferably located at a distance of 1 mm or more, more preferably 3 mm or more, still more preferably 5 mm or more, from the crystal growth plane of the seed substrate. Within this range, a polycrystal generated from the susceptor surface is prevented from eroding the growth plane of the nitride semiconductor crystal.

### (Reserver)

In the reserver 405, a raw material of the nitride semiconductor to be grown is charged. For example, in the case of growing a Group III-V nitride semiconductor, a raw material working out to a Group III source is charged. Examples of the raw material working out to a Group III source include Ga, Al and In.

A gas capable of reacting with the raw material charged into the reserver 405 is supplied through the inlet 403 for introducing a gas into the reserver 405. For example, when a raw material working out to a Group III source is charged into the reserver 405, an HCl gas can be supplied through the inlet tube 403.

At this time, a carrier gas may be supplied together with the HCl gas through the inlet tube 403. Examples of the carrier gas include an inert gas such as hydrogen, nitrogen, He, Ne and Ar. A mixture of these gases may be also used.

### (Nitrogen Source (Ammonia), Carrier Gas, Dopant Gas)

A raw material gas working out to a nitrogen source is supplied through the inlet tube 404. Usually, NH₃ is supplied. Also, a carrier gas is supplied through the inlet tube 401. Examples of the carrier gas is the same as those of the carrier gas supplied through the inlet tube 404. This carrier gas also has an effect of separating a raw material gas nozzle and preventing a polycrystal from attaching to the nozzle tip.

Also, a dopant gas may be supplied through the inlet tube 402. For example, an n-type dopant gas such as SiH₄, SiH₂Cl₂ and H₂S can be supplied.

### (Gas Introduction Method)

The above-described gases supplied through the inlet tubes 401 to 404 may be supplied through a different inlet tubes by replacing each other. Also, the raw material gas working out to a nitrogen source and the carrier gas may be mixed and supplied through the same inlet tube. Furthermore, the carrier gas may be mixed through another inlet tube. These supply modes can be appropriately determined according to, for example, the size or shape of the reactor 400, the reactivity of the raw material, or the intended crystal growth rate.

### (Installation Place of Exhaust Tube)

The gas exhaust tube 408 may be installed on the top, bottom or side surface of the inner wall of the reactor. In view of dust falling, the exhaust tube 408 is preferably located in the lower part than the crystal growth end and is more preferably installed on the bottom surface of the reactor as in Fig. 4.

### (Crystal Growth Conditions)

In the present invention, the crystal growth is performed usually at 950 to 1,120°C, preferably at 970 to 1,100°C, more preferably at 980 to 1,090°C, still more preferably at 990 to 1,080°C. Because, within this range, a nitride semiconductor crystal having a mirror plane is readily obtained.

The pressure in the reactor is preferably from 10 to 200 kPa, more preferably from 30 to 150 kPa, still more preferably from 50 to 120 kPa. Because, within this range, a nitride semiconductor crystal having a mirror plane is readily obtained.

### (Crystal Growth Rate)

In the present invention, the growth rate in the crystal growth varies depending on the growth method, the growth temperature, the supply amount of the raw material gas, the crystal growth plane orientation or the like but is generally from 5 to 500 µm/h, preferably 10 µm/h or more, more preferably 50 µm/h or more, still more preferably 70 µm or more. Because, within this range, the productivity can be more increased.

The growth rate can be controlled by appropriately setting, in addition to the above, the kind or flow rate of the carrier gas, the distance from supply port to the crystal growth end, or the like.

### (Area of Nitride Semiconductor Crystal)

According to the production process of the present invention, a nitride semiconductor crystal having a large principal plane area can be easily obtained. The area of the principal plane of the nitride semiconductor crystal can be appropriately adjusted by the size of the crystal growth plane of the seed substrate or the crystal growth time.

According to the production process of the present invention, for example, the principal plane area of, the nitride semiconductor crystal can be made to be as large as 500 mm² or more, 750 mm² or more, 1,500 mm² or more, 2,500 mm² or more, or 10,000 mm² or more.

### (Nitride Semiconductor Crystal)

The nitride semiconductor crystal provided by the present invention is not particularly limited in its kind and, specifically, includes a Group III nitride semiconductor crystal. More specific examples include gallium nitride, aluminum nitride, indium nitride, and mixed crystal thereof.

The Group III nitride semiconductor crystal of the present invention is a crystal having a principal plane except for a (0001) plane, where the diameter is within 2 inches and the off-angle distribution is 1° or less. The principal plane except for a (0001) plane includes, for example, a {10-10} plane, a {11-20} plane, a (10-11) plane and a (20-21) plane.

Also, the Group III nitride semiconductor crystal of the present invention is a Group III nitride semiconductor crystal having a principal plane inclined at an off-angle of 0 to 65° with respect to the {10-10} plane of a hexagonal crystal, having a dislocation penetrating the surface of the principal plane, and having a thickness of 100 µm to 5 cm, wherein the off-angle distribution in the [0001] axis direction of the [10-10] axis per 2 inches of the Group III nitride semiconductor crystal is within ±0.93°.

The "principal plane of the Group III nitride semiconductor crystal" as used in the present invention indicates a widest plane in the Group III nitride semiconductor crystal and is not particularly limited as long as it is a plane inclined at an off-angle of 0 to 65° with respect to a {10-10} plane of a hexagonal crystal.

Examples thereof include a (10-11) plane and a (10-1-1) plane each having an off-angle of 28° with respect to a {10-10} plane; a (10-12) plane and a (10-1-2) plane each having an off-angle of 47° with respect to a {10-10} plane; a (10-13) plane and a (10-1-3) plane each having an off-angle of 58° with respect to {10-10} plane; a (10-14) plane and a (10-1-4) plane each having an off-angle of 65° with respect to a {10-10} plane; and a (20-21) plane and a (20-2-1) plane each having an off-angle of 15° with respect to a {10-10} plane.

Also, the Group III nitride semiconductor crystal of the present invention grows in the principal plane direction and therefore, is characterized by having a dislocation penetrating the surface of the principal plane. The dislocation penetrating the surface of the principal plane corresponds to a dark spot appearing at the observation in cathode luminescence (CL) measurement. Accordingly, it can be said that the average dark spot density at the CL observation of the principal plane of the crystal is the density of dislocations penetrating the surface of the principal plane.

The density of dislocations penetrating the surface of the principal plane is not particularly limited but is preferably 5×10⁴ cm⁻² or more, more preferably 5×10⁵ cm⁻² or more, still more preferably 7×10⁵ cm⁻² or more, and is preferably 2×10⁸ cm⁻² or less. Within this range, the residual strain of the crystal can be reduced and at the same time, the emission efficiency can prevented from reduction due to the dislocation.

The dislocation usually extends in parallel to the crystal growth direction and therefore, the ratio of the penetrating dislocation present, for example, on the surface of the principal plane of the crystal obtained by slicing in the direction parallel to the growth direction is estimated to be extremely low.

The thickness of the Group III nitride semiconductor crystal of the present invention is preferably 100 µm or more, more preferably 1 mm or more, still more preferably 5 mm or more, and usually, the thickness is preferably 5 cm or less.

The area of the principal plane of the crystal is preferably larger and may be, for example, 100 mm² or more. The area is preferably 500 mm² or more, more preferably 750 mm² or more, and may be 1,500 mm² or more, 2,500 mm² or more, or 10,000 mm² or more.

In the Group III nitride semiconductor crystal of the present invention, the off-angle distribution in the [0001] axis direction of the [10-10] axis is within ±0.93°, preferably within ±0.75°, more preferably within +0.50°, still more preferably within ±0.30°, per 2 inches

That is, the Group III nitride semiconductor crystal of the present invention has crystal axes aligned in a single crystal, and in a Group III nitride semiconductor substrate obtained by slicing such a Group III nitride semiconductor crystal, the tilts of crystal axes in the inside are aligned, which eliminates the problem that fabrication of, for example, a light emitting device involves variation of the emission wavelength as described above.

Also, the Group III nitride semiconductor crystal of the present invention obtained, for example, by growing the crystal on a plurality of seed substrates is advantageous particularly in that a crystal having a large area can be obtained and furthermore, advantageous in that by disposing the seed substrates as in the method above, the tilts of crystal axes in the entire large-area crystal obtained can be aligned over a wide range.

As the characteristic of such a case, for example, in a crystal grown above the bonding part of seed substrates, the amount of off-angle change per 1 mm of crystal tends to be larger than in a crystal grown on a single seed substrate.

Accordingly, the Group III nitride semiconductor crystal of the present invention preferably allows for the presence of a region where the amount of off-angle change per I mm of crystal exceeds 0.015°, more preferably a region where the amount exceeds 0.03°, still more preferably a region where the amount exceeds 0.056°.

Also, in the Group III nitride semiconductor crystal of the present invention, a plurality of regions where the amount of off-angle change per 1 mm of crystal exceeds 0.03° are preferably present.

Furthermore, in the Group III nitride semiconductor crystal of the present invention, the carrier concentration is preferably from 1×10¹⁸ to 5×10¹⁸ cm⁻³.

### (Use Application of Nitride Semiconductor Crystal)

The nitride semiconductor crystal obtained by the production process of the present invention can be used for various applications and is useful particularly as a substrate of a light emitting diode such as ultraviolet, blue or green light emitting diode, a light emitting element on a relatively short wavelength side, such as semiconductor laser, and a semiconductor device such as electronic device. It is also possible to obtain a larger nitride semiconductor crystal by using, as the seed substrate, the nitride semiconductor crystal produced by the production process of the present invention.

### EXAMPLES

The characteristics of the present invention are described in greater detail below by referring to Examples and Comparative Examples. The materials, amounts used, ratios, processing contents, processing procedures and the like employed in the following Examples can be appropriately changed as long as they do not deviate from the purport of the present invention. Accordingly, the scope of the present invention should not be construed as being limited to the following specific examples.

### [Example 1]

A total of three seed substrates differing in the off-angle were prepared, which are
a 330 um-thick rectangular parallelepiped having a length of 25 mm in the [11-20] direction and 5 mm in the [0001] direction,
and include
one (10-10) plane gallium nitride seed substrate having an off-angle of -0.30° in the [0001] direction,
one (10-10) plane gallium nitride seed substrate having an off-angle of -0.01° in the [0001] direction, and
one (10-10) plane gallium nitride substrate having an off-angle of +0.30° in the [0001] direction.

The degree of parallelism between the front and back surfaces of the (10-10) plane of the seed substrate was within 0.5°. As the bonding plane, a (0001) plane and a (000-1) plane were selected.

As shown in Fig. 5(a), three seed substrates were arranged in three rows in the [0001] direction on the susceptor such that the cross-section of the (0001) plane and the cross-section of the (000-1) plane face each other and the degree of parallelism between the cross-sections is within 0.5°. The seed substrates were arranged such that with respect to the M-axis ([10-10] axis) of the seed substrate disposed in the center, the M-axis ([10-10] axis) of the seed substrate disposed on the outer side extends toward the outside along the way from the back surface side to the front surface side of the seed substrate. Specifically, the off-angles in the [0001] direction of the seed substrates were set to -0.30°, -0.01° ° and +0.30° from the [0001] side.

The susceptor was disposed in the reactor 400, and the temperature in the reaction chamber was raised to 1,020°C to grow a gallium nitride single crystal film for 40 hours. In this single crystal growth step, the growth pressure was set to 1.01×10⁵ Pa, the partial pressure of a GaCl gas G3 was set to 1.85×10² Pa, and the partial pressure of an NH₃ gas G4 was set to 7.05×10³ Pa.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction of the M-axis ([10-10] axis) was measured by the X-ray diffraction method and found to be -0.22° at A in Fig. 6, -0.10° at B, and +0.16° at C. Also, the tilt angle distribution in the C-axis ([0001] axis) direction in the plane of the obtained free-standing substrate was 0.37°. The tilt angle distribution as used herein indicates the off-angle variation. The dimension of 2 inches was converted to 50 mm.

The tilt angle distribution in the C-axis ([0001] axis) direction in the plane of the obtained free-standing substrate when converted in terms of 2 inches was +0.93°. The amount of off-angle change in the region above the boundary region between a seed substrate and a seed substrate and found to be 0.13°/mm in the boundary region on the +C side and 0.07°/mm in the boundary region on the -C side. The radius of curvature of the crystal axis in the C-axis ([0001] axis) direction was 1.5 m.

The X-ray rocking curve full width at half maximum of the obtained free-standing substrate was 56 arc-second by (10-10) plane symmetric reflection when an X-ray beam was incident perpendicularly to the [0001] direction. With respect to the obtained free-standing substrate, the average dark spot density by CL measurement in the region above the seed substrate was 4.8×10⁶ cm⁻², and the average dark spot density by CL measurement in the region above the boundary region between a seed and a seed was 2.6×10⁷ cm⁻².

Fig. 5(b) schematically shows the production steps of the gallium nitride substrate of Example 1. In Fig. 5(b), 501 denotes a seed substrate composed of three seed substrates differing in the off-angle, 502 denotes a gallium nitride single crystal produced by growing it on the seed substrate 501, and 503 denotes three (10-10) plane free-standing substrates produced by slicing the gallium nitride single crystal 502 at dashed-line portions.

### [Example 2]

As described below, the process was performed in the same manner as in Example 1 except that seed substrates were sequentially disposed by using seed substrates having off-angles different from those in Example 1.

A total of three seed substrates differing in the off-angle, that is,
one (10-10) plane gallium nitride seed substrate having an off-angle of -5.28° in the [0001] direction,
one (10-10) plane gallium nitride seed substrate having an off-angle of -5.03° in the [0001] direction, and
one (10-10) plane gallium nitride substrate having an off-angle of -4.71° in the [0001] direction,
were prepared.

The seed substrates were arranged such that with respect to the M-axis ([10-10] axis) of the seed substrate disposed in the center, the M-axis ([10-10] axis) of the seed substrate disposed on the outer side extends toward the outside along the way from the back surface side to the front surface side of the seed substrate. Specifically, as shown in Fig. 7(a), the off-angles in the [0001] direction of the seed substrates were set to -5.28°, -5.03° and -4.71° from the [0001] side.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction of the M-axis ([10-10] axis) was measured by the X-ray diffraction method and found to be -4.98° at A in Fig. 6, -4.82° at B, and -4.62° at C. Also, the tilt angle distribution in the C-axis ([0001] axis) direction in the plane of the obtained free-standing substrate was 0.36°.

The tilt angle distribution in the C-axis ([0001] axis) direction in the plane of the obtained free-standing substrate when converted in terms of 2 inches was ±0.90°. The radius of curvature of the crystal axis in the C-axis ([0001] axis) direction was 1.5 m. These results reveal that a free-standing substrate having the same surface off-angle variation as in Example 1 was obtained.

The X-ray rocking curve full width at half maximum of the obtained free-standing substrate was 47 arc-second by (10-10) plane symmetric reflection when an X-ray beam was incident perpendicularly to the [0001] direction.

With respect to the obtained free-standing substrate, the average dark spot density by CL measurement in the region above the seed substrate was 2.5×10⁶ cm⁻², and the average dark spot density by CL measurement in the region above the boundary region between a seed substrate and a seed substrate was 7.5×10⁶ cm⁻².

Fig. 7(b) schematically shows the production steps of the gallium nitride substrate of Example 2. In Fig. 7(b), 701 denotes a seed substrate composed of three seed substrates differing in the off-angle, 702 denotes a gallium nitride single crystal produced by growing it on the seed substrate 701, and 703 denotes three (10-10) plane free-standing substrates produced by slicing the gallium nitride single crystal 702 at dashed-line portions.

### [Example 3]

As described below, the process was performed in the same manner as in Example 1 except that seed substrates were sequentially disposed by using seed substrates having off-angles different from those in Example 1.

A total of three seed substrates differing in the off-angle, that is,
one (10-10) plane gallium nitride seed substrate having an off-angle of -5.51° in the [0001] direction,
one (10-10) plane gallium nitride seed substrate having an off-angle of -5.01° in the [0001] direction, and
one (10-10) plane gallium nitride substrate having an off-angle of -4.50° in the [0001] direction,
were prepared.

The seed substrates were arranged such that with respect to the M-axis ([10-10] axis) of the seed substrate disposed in the center, the M-axis ([10-10] axis) of the seed substrate disposed on the outer side extends toward the outside along the way from the back surface side to the front surface side of the seed substrate. Specifically, as shown in Fig. 8(a), the off-angles in the [0001] direction of the seed substrates were set to -5.51°, -5.01 ° and -4.50° from the [0001] side.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction of the M-axis ([10-10] axis) was measured by the X-ray diffraction method and found to be -4.95° at A in Fig. 6, -5.00° at B, and -5.04° at C. Also, the tilt angle distribution in the C-axis ([0001] axis) direction in the plane of the obtained free-standing substrate was 0.09°.

The tilt angle distribution in the C-axis ([0001] axis) direction in the plane of the obtained free-standing substrate when converted in terms of 2 inches was ±0.23°. The radius of curvature of the crystal axis in the C-axis ([0001] axis) direction was 6.0 m. These results reveal that a tree-standing substrate having a smaller surface off-angle variation than in Example 1 was obtained.

The X-ray rocking curve full width at half maximum of the obtained free-standing substrate was 44 arc-second by (10-10) plane symmetric reflection when an X-ray beam was incident perpendicularly to the [0001] direction. With respect to the obtained free-standing substrate, the average dark spot density by CL measurement in the region above the seed substrate was 2.8×10⁶ cm⁻², and the average dark spot density by CL measurement in the region above the boundary region between a seed substrate and a seed substrate was 7.6×10⁶ cm⁻².

Fig. 8(b) schematically shows the production steps of the gallium nitride substrate of Example 3. In Fig. 8(b), 801 denotes a seed substrate composed of three seed substrates differing in the off-angle, 802 denotes a gallium nitride single crystal produced by growing it on the seed substrate 801, and 803 denotes three (10-10) plane free-standing substrates produced by slicing the gallium nitride single crystal 802 at dashed-line portions.

### [Example 4]

Twenty (10-10) plane gallium nitride seed substrates having an off-angle of -5.6 to -4.4° in the [0001] direction were prepared, which are
a 330 um-thick rectangular parallelepiped having a length of 25 mm in the [11-20] direction and 5 mm in the [0001] direction.

The degree of parallelism between the front and back surfaces of the (10-10) plane of the seed substrate was within 0.5°.

As the bonding plane, a (0001) plane and a (000-1) plane were selected.

As shown in Fig. 9(a), twenty seed substrates were arranged in ten rows in the [0001] direction and two rows in the [11-20] direction on the susceptor such that the cross-section of the (0001) plane and the cross-section of the (000-1) plane face each other or the (11-20) plane and the (-1-120) plane face each other and the degree of parallelism between the cross-sections is within 0.5°.

The seed substrates were arranged such that with respect to the M-axis ([10-10] axis) of the seed substrate on the center side, the M-axis ([10-10] axis) of the seed substrate on the outer side always extends toward the outside along the way from the back surface side to the front surface side of the seed substrate. That is, the seed substrates were arranged such that the off-angle in the [0001] direction of the seed substrate increases in the off-angle value (decreases in the absolute value of the off-angle) along the way from [0001] to [000-1].

The growth of the gallium nitride single crystal film was performed under the same conditions as in Example 1.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 440 um-thick (10-10) plane having a diameter of 2 inches were produced by general slicing and polishing. The area of the principal plane was 1,963 mm².

The tilt angle distribution in the C-axis ([0001] axis) direction in the plane of the obtained free-standing substrate was measured by the X-ray diffraction method and found to be 0.941° and in terms of 2 inches, ±0.47°. The radius of curvature of the crystal axis in the C-axis direction was 3.0 m.

The X-ray rocking curve full width at half maximum of the obtained free-standing substrate was 45 arc-second by (10-10) plane symmetric reflection when an X-ray beam was incident perpendicularly to the [0001] direction. With respect to the obtained free-standing substrate, the average dark spot density by CL measurement in the region above the seed substrate was 2,7×10⁶ cm⁻², and the average dark spot density by CL measurement in the region above the boundary region between a seed substrate and a seed substrate was 8.1×10⁶ cm⁻².

Fig. 9(b) schematically shows the production steps of the gallium nitride substrate of Example 4. In the Figure, 901 denotes a seed substrate composed of three seed substrates differing in the off-angle, 902 denotes a gallium nitride single crystal produced by growing it on the seed substrate 901, and 903 denotes three (10-10) plane free-standing substrates produced by slicing the gallium nitride single crystal 902 at dashed-line portions.

### [Comparative Example 1]

As described below, the process was performed in the same manner as in Example 1 except that seed substrates were sequentially disposed by using seed substrates having off-angles different from those in Example 1.
A total of three seed substrates, that is,
one (10-10) plane gallium nitride seed substrate having an off-angle of +0.01° in the [0001] direction,
one (10-10) plane gallium nitride seed substrate having an off-angle of -0.02° in the [0001] direction, and
one (10-10) plane gallium nitride substrate having an off-angle of +0.02° in the [0001] direction,
were prepared.

As shown in Fig. 10(a), the off-angles in the [0001] direction of the seed substrates were set to +0.01°, -0.02° and +0.02° from the [0001] side.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction was measured by the X-ray diffraction method and found to be -0.36° at A in Fig. 6, -0.03° at B, and +0.30° at C. Also, the tilt angle distribution in the C-axis ([0001] axis) direction in the plane of the obtained free-standing substrate was 0.66°.

The tilt angle distribution in the C-axis ([0001] axis) direction in the plane of the obtained free-standing substrate when converted in terms of 2 inches was ±1.65°. The radius of curvature of the crystal axis in the C-axis ([0001] axis) direction was 0.8 m. These results reveal that a free-standing substrate having a larger surface off-tangle variation than in Example 1 was obtained.

The X-ray rocking curve full width at half maximum of the obtained free-standing substrate was 57 arc-second by (10-10) plane symmetric reflection when an X-ray beam was incident perpendicularly to the [0001] direction. With respect to the obtained free-standing substrate, the average dark spot density by CL measurement in the region above the seed substrate was 4.6×10⁶ cm⁻², and the average dark spot density by CL measurement in the region above the boundary region between a seed substrate and a seed substrate was 2.3×10⁷ cm⁻².

Fig. 10(b) schematically shows the production steps of the gallium nitride substrate of Comparative Example 1. In the Figure, 1001 denotes a seed substrate composed of three seed substrates having almost the same off-angle, 1002 denotes a gallium nitride single crystal produced by growing it on the seed substrate 1001, and 1003 denotes three (10-10) plane free-standing substrates produced by slicing the gallium nitride single crystal 1002 at dashed-line portions.

### [Comparative Example 2]

As described below, the process was performed in the same manner as in Example 1 except that seed substrates were sequentially disposed by using seed substrates having off-angles different from those in Example 1.
A total of three seed substrates, that is,
one (10-10) plane gallium nitride seed substrate having an off-angle of -4.99° in the [0001] direction,
one (10-10) plane gallium nitride seed substrate having an off-angle of -5.01° in the [0001] direction, and
one (10-10) plane gallium nitride substrate having an off-angle of -5.00° in the [0001] direction,
were prepared.

As shown in Fig. 11(a), the off-angles in the [0001] direction of the seed substrates were set to -4.99°, -5.01° and -5.00° from the [0001] side.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction was measured by the X-ray diffraction method and found to be -5.31° at A in Fig. 6, -4.99° at B, and -4.68° at C. Also, the tilt angle distribution in the C-axis ([0001] axis) direction in the plane of the obtained free-standing substrate was 0.63°.

The tilt angle distribution in the C-axis ([0001] axis) direction in the plane of the obtained free-standing substrate when converted in terms of 2 inches was ±1.58°. The radius of curvature of the crystal axis in the C-axis ([0001] axis) direction was 0.9 m. Thus, a free-standing substrate having a larger surface off-angle variation than in Example 1 was obtained.

The X-ray rocking curve full width at half maximum of the obtained free-standing substrate was 45 arc-second by (10-10) plane symmetric reflection when an X-ray beam was incident perpendicularly to the [0001] direction. With respect to the obtained free-standing substrate, the average dark spot density by CL measurement in the region above the seed substrate was 3.0×10⁶ cm⁻², and the average dark spot density by CL measurement in the region above the boundary region between a seed substrate and a seed substrate was 9.0×10⁷ cm⁻².

Fig. 11(b) schematically shows the production steps of the gallium nitride substrate of Comparative Example 2. In the Figure, 1101 denotes a seed substrate composed of three seed substrates having almost the same off-angle, 1102 denotes a gallium nitride single crystal produced by growing it on the seed substrate 1101, and 1103 denotes three (10-10) plane free-standing substrates produced by slicing the gallium nitride single crystal 1102 at dashed-line portions.

### [Comparative Example 3]

As described below, the process was performed in the same manner as in Example 1 except that seed substrates were sequentially disposed by using seed substrates having off-angles different from those in Example 1.
A total of three seed substrates, that is,
one (10-10) plane gallium nitride seed substrate having an off-angle of -5.01° in the [0001] direction,
one (10-10) plane gallium nitride seed substrate having an off-angle of -5.00° in the [0001] direction, and
one (10-10) plane gallium nitride substrate having an off-angle of -4.98° in the [0001] direction,
were prepared.

The seed substrates were arranged such that with respect to the M-axis ([10-10] axis) of the seed substrate disposed in the center, the M-axis ([10-10] axis) of the seed substrate disposed on the outer side extends toward the outside. Specifically, as shown in Fig. 12(a), the off-angles in the [0001] direction of the seed substrates were set to -5.01°, -5.00° and -4.98° from the [0001] side.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction was measured by the X-ray diffraction method and found to be -5.25° at A in Fig. 6, -5.00° at B, and -4.77° at C. Also, the tilt angle distribution in the C-axis direction in the plane of the obtained free-standing substrate was 0.48°.

The tilt angle distribution in the C-axis ([0001] axis) direction when converted in terms of 2 inches was ±1.20°. The radius of curvature of the crystal axis in the C-axis ([0001] axis) direction was 1.1 m. Thus, a free-standing substrate having a larger surface off-angle variation than in Example 1 was obtained.

The X-ray rocking curve full width at half maximum of the obtained free-standing substrate was 46 arc-second by (10-10) plane symmetric reflection when an X-ray beam was incident perpendicularly to the [0001] direction. With respect to the obtained free-standing substrate, the average dark spot density by CL measurement in the region above the seed substrate was 2.8×10⁶ cm⁻², and the average dark spot density by CL measurement in the region above the boundary region between a seed substrate and a seed substrate was 8.1×10⁷ cm⁻².

Fig. 12(b) schematically shows the production steps of the gallium nitride substrate of Comparative Example 3. In the Figure, 1201 denotes a seed substrate composed of three seed substrates having almost the same off-angle, 1202 denotes a gallium nitride single crystal produced by growing it on the seed substrate 1201, and 1203 denotes three (10-10) plane free-standing substrates produced by slicing the gallium nitride single crystal 1202 at dashed-line portions.

### [Comparative Example 4]

As described below, the process was performed in the same manner as in Example 1 except that seed substrates were sequentially disposed by using seed substrates having off-angles different from those in Example 1.

A total of three seed substrates differing in the off-angle, that is,
one (10-10) plane gallium nitride seed substrate having an off-angle of -4.71° in the [0001] direction,
one (10-10) plane gallium nitride seed substrate having an off-angle of -5.03° in the [0001] direction, and
one (10-10) plane gallium nitride substrate having an off-angle of -5.28° in the [0001] direction,
were prepared.

The seed substrates were arranged such that with respect to the M-axis ([10-10] axis) of the seed substrate disposed in the center, the M-axis ([10-10] axis) of the seed substrate disposed on the outer side extends toward the inside. Specifically, as shown in Fig. 13(a), the off-angles in the [0001] direction of the seed substrates were set to -4.71°, -5.03° and -5.28° from the [0001] side.

After the completion of the single crystal growth step, the temperature was lowered to room temperature and the crystal grown was taken out, as a result, it was found that the regions above the boundary region between a seed substrate and a seed substrate were combined and the outer peripheral part of the disposed seed substrate extended 2 mm in each of the [11-20] direction and the [-1-120] direction, 2 mm in the [0001] direction, and 2 mm in the [0001] direction. The growth in the [10-10] direction was 3.5 mm. Three free-standing substrates each having, as the principal plane, a 330 um-thick rectangular (10-10) plane of 29 mm in the [11-20] direction and 19 mm in the [0001] direction were produced by general slicing and polishing. The area of the principal plane was 551 mm².

The off-angle in the C-axis ([0001] axis) direction was measured by the X-ray diffraction method and found to be -5.61° at A in Fig. 6, -5.00° at B, and -4.42° at C. Also, the tilt angle distribution in the C-axis ([0001] axis) direction in the plane of the obtained free-standing substrate was 1.19°.

The tilt angle distribution in the C-axis ([0001] axis) direction when converted in terms of 2 inches was ±2.98°. The radius of curvature of the crystal axis in the C-axis ([0001] axis) direction was 0.5 m. Thus, a free-standing substrate having a larger surface off-angle variation than in Example 1 was obtained.

The X-ray rocking curve full width at half maximum of the obtained free-standing substrate was 45 arc-second by (10-10) plane symmetric reflection when an X-ray beam was incident perpendicularly to the [0001] direction. With respect to the obtained free-standing substrate, the average dark spot density by CL measurement in the region above the seed substrate was 2.6×10⁶ cm⁻², and the average dark spot density by CL measurement in the region above the boundary region between a seed substrate and a seed substrate was 8.5×10⁷ cm⁻².

Fig. 13(b) schematically shows the production steps of the gallium nitride substrate of Comparative Example 4. In the Figure, 1301 denotes a seed substrate composed of three seed substrates having almost the same off-angle, 1302 denotes a gallium nitride single crystal produced by growing it on the seed substrate 1301, and 1303 denotes three (10-10) plane free-standing substrates produced by slicing the gallium nitride single crystal 1302 at dashed-line portions.

The seed substrate conditions in Examples 1 to 4 and Comparative Examples 1 to 4 and the evaluation results of the gallium nitride single crystal grown are shown in Table 1. A nitride semiconductor crystal having a small surface off-angle variation could be obtained by using the seed substrate conditions of Examples 1 to 4.

**[Table 1]**

| | | | Example 1 | Example 2 | Example 3 | Example 4 | Comparative Example 1 | Comparative Example 2 | Comparative Example 3 | Comparative Example 4 |
|---|---|---|---|---|---|---|---|---|---|---|
| Seed substrate | Number of substrates arrayed [°] | [11-20] Direction | 1 | 1 | 1 | 2 | 1 | 1 | 1 | 1 |
| | | [0001] Direction | 3 | 3 | 3 | 10 | 3 | 3 | 3 | 3 |
| | Off-angle in [0001] direction [°] | [0001] Side | -0.30 | -5.28 | -5.51 | -5.60 | +0.01 | -4.99 | -5.01 | -4.71 |
| | | Center | -0.01 | -5.03 | -5.01 | -5.00 | -0.02 | -5.01 | -5.00 | -5.03 |
| | | [000-1] Side | +0.30 | -4.71 | -4.50 | -4.40 | +0.02 | -5.00 | -4.98 | -5.28 |
| Self-standing substrate produced | Crystal size [mm] | [11-20] Direction | 29 | 29 | 29 | circle of 50 mm in diameter | 29 | 29 | 29 | 29 |
| | | [0001] Direction | 19 | 19 | 19 | | 19 | 19 | 19 | 19 |
| | | [10-10] Direction | 0.33 | 0.33 | 0.33 | 0.33 | 0.33 | 0.33 | 0.33 | 0.33 |
| | Radius of curvature [m] | | 1.5 | 1.5 | 6.0 | 3.0 | 0.8 | 0.9 | 1.1 | 0.5 |
| | In-plane off-angle distribution [°] | | 0.37 | 0.36 | 0.09 | 0.94 | 0.66 | 0.63 | 0.48 | 1.19 |
| | X-Ray rocking curve [sec.] | | 56 | 47 | 44 | 45 | 57 | 45 | 46 | 45 |

### [Reference Example]

As described below, the process was performed in the same manner as in Example I except that unlike Example 1, the crystal was grown on one seed without arranging a plurality of seed substrates.

One (10-10) plane gallium nitride seed substrate having an off-angle of -0.240° in the [0001] direction, which was a 330 um-thick rectangular parallelepiped having a length of 25 mm in the [11-20] direction and 5 mm in the [0001] direction, was prepared.

After the completion of the single crystal growth step, the temperature was lowered to room temperature and the crystal grown was taken out, as a result, it was found that the outer peripheral part of the seed substrate extended 2 mm in each of the [11-20] direction and the [-1-120] direction, 2 mm in the [0001] direction, and 2 mm in the [000-1] direction. The growth in the [10-10] direction was 3.5 mm. Three free-standing substrates each having, as the principal plane, a 330 um-thick rectangular (10-10) plane of 29 mm in the [11-20] direction and 9 mm in the [0001] direction were produced by general slicing and polishing. The area of the principal plane was 261 mm².

The off-angle in the C-axis ([0001] axis) direction was measured by the X-ray diffraction method, as a result, the tilt angle distribution in the C-axis ([0001] axis) in the substrate plane was 0.22°. The tilt distribution in the C-axis ([0001] axis) direction when converted in terms of 2 inches was ±0.61°. Also, the amount of off-angle change was 0.012°/mm.

This application is based on Japanese Patent Application (Patent Application No. 2009-132264) filed on June 1, 2009 and Japanese Patent Application (Patent Application No. 2009-190070) filed on August 19, 2009, the contents of which are incorporated herein by way of reference.

### INDUSTRIAL APPLICABILITY

The present invention is effective in producing a semiconductor substrate with a wide area used mainly in mass production of a semiconductor element and reducing the quality variation of semiconductor elements mass-produced using the semiconductor substrate.

### DESCRIPTION OF REFERENCE NUMERALS AND SIGNS

- 101: Seed substrate having aligned off-angles
- 102: Nitride semiconductor crystal grown on 101
- 103: Substrate produced by slicing 102 at dashed lines
- 201: A plurality of seed substrates differing in off-angle
- 202: Nitride semiconductor crystal grown on 201
- 203: Substrate produced by slicing 202 at dashed lines
- 400: Reactor
- 401: Piping for carrier gas
- 402: Piping for dopant gas
- 403: Piping for Group III raw material
- 404: Piping for Group V raw material
- 405: Piping for HCl gas
- 405: Preserver for Group III raw material
- 406: Heater
- 407: Susceptor
- 408: Exhaust tube
- 501: Seed substrates in Example 1 and arrangement thereof
- 502: Gallium nitride single crystal grown on 501
- 503: Substrate produced by slicing 502 at dashed lines
- 701: Seed substrates in Example 2 and arrangement thereof
- 702: Gallium nitride single crystal grown on 701
- 703: Substrate produced by slicing 702 at dashed lines
- 801: Seed substrates in Example 3 and arrangement thereof
- 802: Gallium nitride single crystal grown on 801
- 803: Substrate produced by slicing 802 at dashed lines
- 901: Seed substrates in Example 4 and arrangement thereof
- 902: Gallium nitride single crystal grown on 901
- 903: Substrate produced by slicing 902 at dashed lines
- 1001: Seed substrates in Comparative Example 1 and arrangement thereof
- 1002: Gallium nitride single crystal grown on 1001
- 1003: Substrate produced by slicing 1002 at dashed lines
- 1101: Seed substrates in Comparative Example 2 and arrangement thereof
- 1102: Gallium nitride single crystal grown on 1101
- 1103: Substrate produced by slicing 1102 at dashed lines
- 1201: Seed substrates in Comparative Example 3 and arrangement thereof
- 1202: Gallium nitride single crystal grown on 1201
- 1203: Substrate produced by slicing 1202 at dashed lines
- 1301: Seed substrates in Comparative Example 4 and arrangement thereof
- 1302: Gallium nitride single crystal grown on 1301
- 1303: Substrate produced by slicing 1302 at dashed lines
- G1: Carrier gas
- G2: Dopant gas
- G3: Group III raw material gas
- G4: Group V raw material gas

## Claims

1. A production process for a nitride semiconductor crystal, comprising growing a semiconductor layer on a seed substrate to obtain a nitride semiconductor crystal, wherein said seed substrate contains a plurality of seed substrates made of the same material, at least one of said plurality of seed substrates differs in the off-angle from the other seed substrates, and a single semiconductor layer is grown by disposing said plurality of seed substrates, such that when said single semiconductor layer is grown on said plurality of seed substrates, the off-angle distribution in said single semiconductor layer becomes smaller than the off-angle distribution in said plurality of seed substrates.

2. The production process for a nitride semiconductor crystal as claimed in claim 1, wherein each of said plurality of seed substrates is composed of a hexagonal semiconductor, the growth plane is substantially {10-10} plane, and at least one of the plurality of seed substrates differs only in the off-angle in either the [0001] axis direction or the [11-20] axis direction from the other seed substrates.

3. The production process for a nitride semiconductor crystal as claimed in claim 1, wherein each of said plurality of seed substrates is composed of a hexagonal semiconductor, the growth plane is substantially {11-20} plane, and at least one of the plurality of seed substrates differs only in the off-angle in either the [0001] axis direction or the [10-10] axis direction from the other seed substrates.

4. The production process for a nitride semiconductor crystal as claimed in claim 1, wherein each of said plurality of seed substrates is composed of a hexagonal semiconductor, the growth plane is substantially (0001) plane or substantially (000-1) plane, and at least one of the plurality of seed substrates differs only in the off-angle in either the [10-10] axis direction or the [11-20] axis direction from the other seed substrates.

5. The production process for a nitride semiconductor crystal as claimed in claim 1, wherein each of said plurality of seed substrates is composed of a hexagonal semiconductor, the growth plane is substantially (0001) plane or substantially (000-1) plane, and at least one of the plurality of seed substrates differs in the off-angle in both the [10-10] axis direction and the [11-20] axis direction from the other seed substrates.

6. The production process for a nitride semiconductor crystal as claimed in claim 1, wherein each of said plurality of seed substrates is composed of a hexagonal semiconductor, the growth plane is substantially {10-10} plane, and at least one of the plurality of seed substrates differs in the off-angle in both the [11-20] axis direction and the [0001] axis direction from the other seed substrates.

7. The production process for a nitride semiconductor crystal as claimed in claim 1, wherein each of said plurality of seed substrates is composed of a hexagonal semiconductor, the growth plane is substantially {11-20} plane, and at least one of the plurality of seed substrates differs in the off-angle in both the [10-10] axis direction and the [0001] axis direction from the other seed substrates.

8. The production process for a nitride semiconductor crystal as claimed in any one of claims 1 to 7, wherein said plurality of seed substrates are disposed while gradually changing the off-angle, such that when a single crystal layer is grown on said plurality of seed substrates, the off-angle variation of said single semiconductor layer is reduced.

9. The production process for a nitride semiconductor crystal as claimed in any one of claims 1 to 8, wherein said plurality of seed substrates are disposed such that the off-angle is gradually changed along the way from near the center to the peripheral part of said plurality of seed substrates.

10. The production process for a nitride semiconductor crystal as claimed in any one of claims 1 to 9, wherein said plurality of seed substrates are disposed such that the crystallographic plane of said plurality of continuing seed substrates forms a convex shape.

11. The production process for a nitride semiconductor crystal as claimed in any one of claims 1 to 10, wherein said plurality of seed substrates are disposed such that the off-angle in an intermediate part of seed consisting of said plurality of seed substrates becomes smaller than the off-angle at both ends of said seed.

12. The production process for a nitride semiconductor crystal as claimed in any one of claims 1 to 11, wherein said plurality of seed substrates are disposed such that the off-angle directions of at least part of adjacent seed substrates out of said plurality of seed substrates become almost the same.

13. The production process for a nitride semiconductor crystal as claimed in any one of claims 1 to 12, wherein each of said plurality of seed substrates comprises at least one member selected from sapphire, SiC, ZnO and a Group III nitride semiconductor.

14. The production process for a nitride semiconductor crystal as claimed in any one of claims 1 to 13, wherein said single semiconductor layer is at least one member selected from gallium nitride, aluminum nitride, indium nitride and a mixed crystal thereof.

15. The production process for a nitride semiconductor crystal as claimed in any one of claims 1 to 14, wherein the single semiconductor layer is grown on said plurality of seed substrates by at least any one of an HVPE method, an MOCVD method, an MBE method, a sublimation method and a PLD method.

16. The production process for a nitride semiconductor crystal as claimed in any one of claims 1 to 15, wherein said plurality of seed substrates are a seed substrate produced by preparing a plurality of ingots made of the same material and cutting out, from each ingot, a portion having a smallest off-angle in said each ingot.

17. The production process for a nitride semiconductor crystal as claimed in any one of claims 1 to 16, wherein said plurality of seed substrates are a plurality of seed substrates which contain at least one seed substrate differing in the off-angle from the other seed substrates, and are produced by cutting-out from an ingot where the tilt angle of the crystal axis is changed along the way from near the center to the peripheral part.

18. The production process for a nitride semiconductor crystal as claimed in claim 16 or 17, wherein said ingot is produced by a semiconductor crystal production process of growing a semiconductor layer on a seed.

19. A Group III nitride semiconductor crystal produced by the production process claimed in any one of claims 1 to 18.

20. A Group III nitride semiconductor crystal having a principal plane except for a (0001) plane, wherein the off-angle distribution is 1° or less within a diameter of 2 inches.

21. A Group III nitride semiconductor crystal with a thickness of 100 µm to 5 cm, which has a principal plane inclined at an off-angle of 0 to 65° with respect to a {10-10} plane of a hexagonal crystal, and has a dislocation penetrating the surface of the principal plane, wherein the off-angle distribution in the [0001] axis direction of the [10-10] axis per 2 inches of said Group III nitride semiconductor crystal is within ±0.93°.

22. The Group III nitride semiconductor crystal as claimed in claim 20 or 21, wherein a region in which the amount of off-angle change per 1 mm of the crystal exceeds 0.015°, is present.

23. The Group III nitride semiconductor crystal as claimed in any one of claims 20 to 22, wherein a region in which the amount of off-angle change per 1 mm of the crystal exceeds 0.056°, is present.

24. The Group III nitride semiconductor crystal as claimed in any one of claims 20 to 23, wherein a region in which the amount of off-angle change per 1 mm of the crystal exceeds 0.03° is present plurally,

25. The Group III nitride semiconductor crystal as claimed in any one of claims 20 to 24, wherein the area of said principal plane is larger than 750 mm².

26. The Group III nitride semiconductor crystal as claimed in any one of claims 20 to 25, wherein the density of dislocations penetrating the surface of the principal plane is from 5×10⁵ to 2×10⁸ cm⁻².
